# EUROPEAN PATENT APPLICATION

(11) **EP 4 738 708 A1**
(43) Date of publication of application: **06.05.2026**
(21) Application number: 25196060.5
(22) Date of filing: 14.08.2025
(51) Int. Cl.: H03K 19/00, H04B 3/04, H04L 25/02

(54) **ON-DIE HIGH SPEED AND LOW POWER SIGNAL TRANSMISSION CIRCUITRY**

(30) Priority: 31.10.2024 US 202463714168 P; 22.07.2025 US 202519276027
(71) Applicant: MEDIATEK INC., Hsinchu City 30078 (TW)
(72) Inventor: LEE, Zwei-Mei, 30078 Hsinchu City (TW); WANG, Ping-Yi, 30078 Hsinchu City (TW)
(74) Representative: Pfenning, Meinig & Partner mbB

(57) **Abstract**

The present invention provides a circuitry (100, 200, 300) including a driver (114, 214), a band-pass filter (120, 220), a routing trace (130, 230) and at least one receiver (140, 144, 240_1 - 240_N, 244_1 - 244_N) is disclosed. The driver (114, 214) is configured to generate a first signal. The band-pass filter (120, 220) is configured to filters the first signal to generate a second signal. The second signal passes through the routing trace (130, 230) to generate a third signal. The at least one receiver (140, 144, 240_1 - 240_N, 244_1 - 244_N) is configured to receive the third signal to generate an output signal.

## Description

### Field of the Invention

The present invention relates to a transmission circuitry.

### Background of the Invention

In a chip, when high-speed signals pass through a long routing trace, such as high-frequency clock signals transmitted over long-distance traces, they often encounter significant signal loss issues. To maintain signal integrity, conventional technologies typically used larger driver circuits or added multiple repeaters along the long routing traces. However, using larger driver circuits increases power consumption, while adding many repeaters in long-distance traces leads to higher power consumption, as well as issues with delay and jitter.

### Summary of the Invention

Therefore, one objective of the present invention is to propose a circuitry that can maintain the integrity of the signal after long-distance transmission, without the need for larger driver circuits or the addition of numerous repeaters along the long routing traces, thereby solving the above-mentioned problems.

This is achieved by a circuitry according to claim 1. The dependent claims pertain to corresponding further developments and improvements.

As will be seen more clearly from the detailed description following below, a circuitry comprising a driver, a band-pass filter, a routing trace and at least one receiver is disclosed. The driver is configured to generate a first signal. The band-pass filter is configured to filters the first signal to generate a second signal. The second signal passes through the routing trace to generate a third signal. The at least one receiver is configured to receive the third signal to generate an output signal.

### Brief Description of the Drawings

FIG. 1 is a diagram illustrating a circuitry according to one embodiment of the present invention.
FIG. 2 is a diagram illustrating a circuitry according to one embodiment of the present invention.
FIG. 3 is a diagram illustrating a circuitry according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

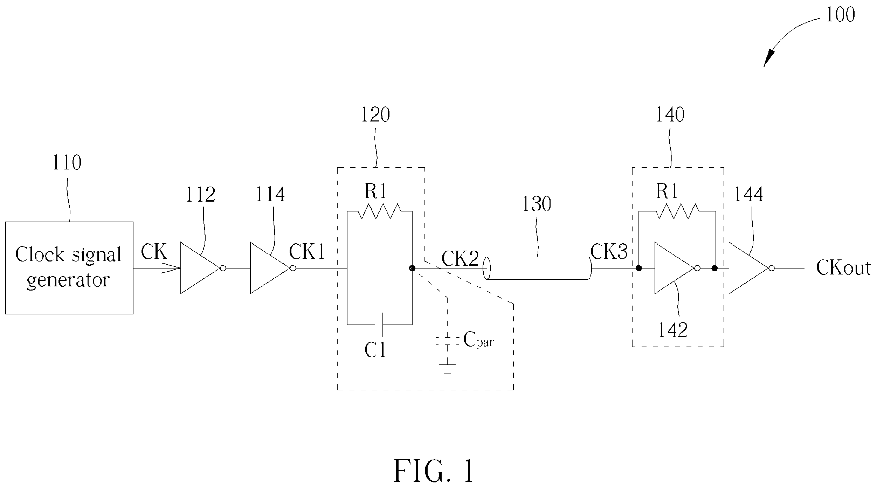

FIG. 1 is a diagram illustrating a circuitry 100 according to one embodiment of the present invention. In this embodiment, the circuitry 100 is a clock signal generation and transmission circuit, and the circuitry 100 is positioned within a chip. As shown in FIG. 1, the circuitry 100 comprises a clock signal generator 110, at least one driver such as two inverters 112 and 114, a band-pass filter 120, a routing trace 130 and a receiver comprising a self-biased inverter 140 and an inverter 144. The band-pass filter 120 is a passive band-pass filter comprising a resistor R1, a capacitor C1 and a parasitic capacitor Cpar, wherein the resistor R1 and the capacitor C1 are connected in parallel, that is a first terminal of the resistor R1 is coupled to a first terminal of the capacitor C1, and a second terminal of the resistor R1 is coupled to a second terminal of the capacitor C1; and the parasitic capacitor Cpar is an equivalent parasitic capacitor seen by the output side of band-pass filter 120. The self-biased inverter 140 comprises an inverter 142 and a resistor R2, wherein a first terminal of the resistor R2 is coupled to an input terminal of the inverter 142, and a second terminal of the resistor R2 is coupled to an output terminal of the inverter 142. In this embodiment, the routing trace 130 is a long interconnect, such as a metal line, more than one millimeter in length (e.g. two millimeters), fabricated using semiconductor processes.

In one embodiment, the length of the routing trace 130 causes significant attenuation of the signal as it passes through, for example, the signal passes through the routing trace 130 will have a loss of 2dB or more at its Nyquist frequency.

The band-pass filter 120 shown in FIG. 1 is for illustrative, and not a limitation of the present invention. In other embodiments, the band-pass filter 120 can be replaced by an active band-pass filter or a RLC (resistor, inductor and capacitor) band-pass filter.

In this embodiment, without a limitation of the present invention, the routing trace 130 directly follows the band-pass filter 120, that is, there is no element intentionally positioned between the routing trace 130 and the band-pass filter 120.

In the operation of the circuitry 100, the clock signal generator 110 generates a clock signal CK, and the clock signal CK passes through the driver (i.e., the inverters 112 and 114) to generate a first clock signal CK1. The band-pass filter 120 filters the first clock signal CK1 to generate a second clock signal CK2. In this case, compared with the first clock signal CK1, the second clock signal CK2 has smaller swing and sharper high-frequency component (i.e., rising and falling edges have steeper slope). Then, the second clock signal CK2 passes through the routing trace 130 to generate a third clock signal CK3. Then, the self-biased inverter 140 with the inverter 144 receives the third clock signal CK3 to generate an output clock signal CKout.

In the embodiment shown in FIG. 1, by using the band-pass filter 120 to generate the clock signal CK2 with smaller swing and sharper high-frequency component, the second clock signal CK2 can be transmitted through the routing trace 130 with minimal degradation from this lossy interconnect. As a result, since the band-pass filter 120 compensates for the routing channel loss of the routing trace 130, the third clock signal CK3 can maintain good quality even without any repeaters (e.g., buffers or inverters) placed on the routing trace 130, or with only a few repeaters along the routing trace 130. In other words, this embodiment can maintain the signal quality of the third clock signal CK3 while minimizing the number of required buffers placed on the routing trace 130.

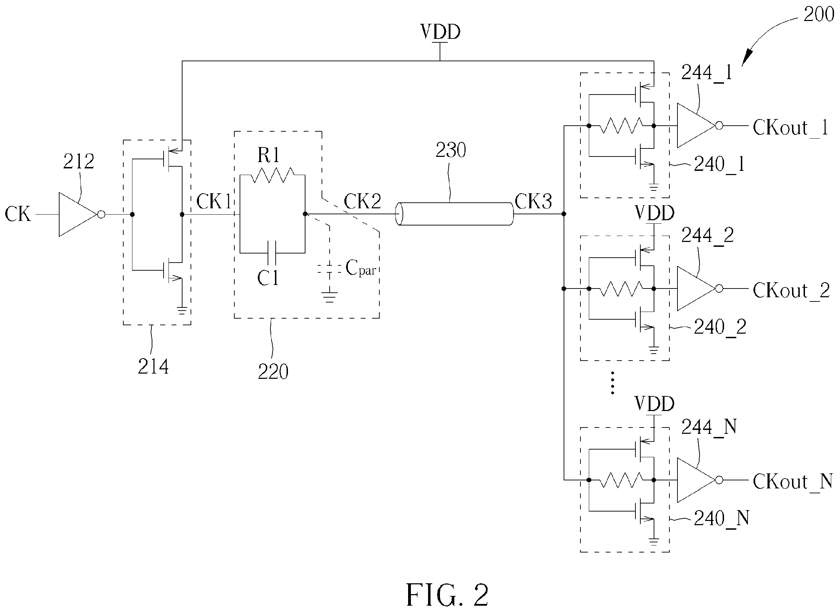

FIG. 2 is a diagram illustrating a circuitry 200 according to one embodiment of the present invention. In this embodiment, the circuitry 200 is a clock distribution circuit, and the circuitry 200 is positioned within a chip. As shown in FIG. 2, the circuitry 200 comprises at least one driver such as two inverters 212 and 214, a band-pass filter 220, a routing trace 230, and multiple receivers, wherein the multiple receivers comprise multiple self-biased inverters 240_1 - 240_N and multiple inverters 244, respectively. The band-pass filter 220 is a passive band-pass filter comprising a resistor R1, a capacitor C1 and a parasitic capacitor Cpar, wherein the resistor R1 and the capacitor C1 are connected in parallel, and the parasitic capacitor Cpar is an equivalent parasitic capacitor seen by the output side of band-pass filter 220 (i.e., seen by CK2). Each of the multiple self-biased inverters 240_1 - 240_N comprises an inverter and a resistor. Each of the inverter 212, 214 and 244 comprises a P-type transistor and an N-type transistor coupled between a supply voltage VDD and a ground voltage. In this embodiment, the routing trace 230 is a long interconnect, such as a metal line, one or two millimeters in length, fabricated using semiconductor processes.

The band-pass filter 220 shown in FIG. 2 is for illustrative, not a limitation of the present invention. In other embodiments, the band-pass filter 220 can be replaced by an active band-pass filter or a RLC band-pass filter.

In the operation of the circuitry 200, a clock signal CK passes through the driver (i.e., the inverters 212 and 214) to generate a first clock signal CK1. The band-pass filter 220 filters the first clock signal CK1 to generate a second clock signal CK2. In this case, compared with the first clock signal CK1, the second clock signal CK2 has smaller swing and sharper high-frequency component (i.e., rising and falling edges have steeper slope). Then, the second clock signal CK2 passes through the routing trace 230 to generate a third clock signal CK3. Then, multiple paths, such as the self-biased inverter 240_1 with the inverter 244_1, self-biased inverter 240_2 with the inverter 244_2, ..., self-biased inverter 240_N with the inverter 244_N, receive the third clock signal CK3 to generate multiple output clock signals CKout_1 - CKout_N, respectively.

In the embodiment shown in FIG. 2, by using the band-pass filter 220 to generate the clock signal CK2 with smaller swing and sharper high-frequency component, the second clock signal CK2 can be transmitted through the routing trace 230 with minimal degradation from this lossy interconnect. As a result, since the band-pass filter 220 compensates for the routing channel loss of the routing trace 230, the third clock signal CK3 can maintain good quality even without any repeaters placed on the routing trace 230, or with only a few repeaters along the routing trace 230. In other words, this embodiment can maintain the signal quality of the third clock signal CK3 while minimizing the number of required buffers placed on the routing trace 230.

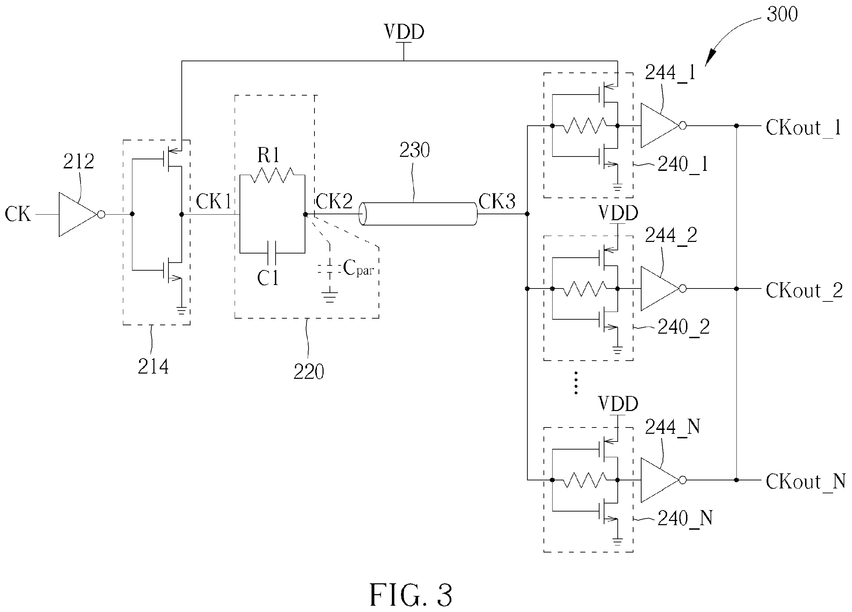

In the embodiment shown in FIG. 2, the output terminals of the inverter 244_1 - 244_N are connected together, to avoid clock skew caused by process-voltage-temperature (PVT) variation of the inverters 244_1 - 244_N, as shown in circuitry 300 of FIG. 3.

In the above embodiments shown in FIG. 1 - FIG. 3, the circuitry 100, 200 or 300 is configured to process clock signal. In other embodiments, however, the circuitry 100, 200 or 300 may process another type of signal, such as data signal or other high-frequency signals. That is, the first clock signal CK1, second clock signal CK2 and third clock signal CK3, output clock signal CKout can be replaced by a first signal, a second signal, a third signal and an output signal, respectively. These alternative designs shall fall within the scope of the present invention.

## Claims

1. A circuitry (100, 200, 300), comprising:
a driver (114, 214), configured to generate a first signal;
a band-pass filter (120, 220), configured to filters the first signal to generate a second signal;
a routing trace (130, 230), wherein the second signal passes through the routing trace to generate a third signal; and
at least one receiver (140, 144, 240_1 - 240_N, 244_1 - 244_N), configured to receive the third signal to generate an output signal.

2. The circuitry (100, 200, 300) of claim 1, wherein the band-pass filter (120, 220) is a passive band-pass filter.

3. The circuitry (100, 200, 300) of claim 2, wherein the band-pass filter (120, 220) comprises a resistor, a capacitor and a parasitic capacitor, a first terminal of the resistor is coupled to a first terminal of the capacitor, a second terminal of the resistor is coupled to a second terminal of the capacitor, the first terminals of the resistor and the capacitor are configured to receive the first signal, and the second terminals of the resistor and the capacitor are configured to output the second signal; and the parasitic capacitor is an equivalent parasitic capacitor seen by an output side of the band-pass filter.

4. The circuitry (100, 200, 300) of any one of claims 1 to 3, wherein the routing trace (130, 230) is directly follows the band-pass filter.

5. The circuitry (100, 200, 300) of any one of claims 1 to 4, wherein the routing trace (130, 230) is a long metal line fabricated using semiconductor processes, which causes an amplitude of the third signal, generated when the second signal passes through the routing trace, to have a loss of 2dB at its Nyquist frequency.

6. The circuitry (100, 200, 300) of any one of claims 1 to 5, wherein there is no repeater, buffer and inverter placed on the routing trace (130, 230).

7. The circuitry (100, 200, 300) of any one of claims 1 to 6, wherein the at least one receiver comprises a self-biased inverter (140, 240_1 - 240_N).

8. The circuitry (200, 300) of any one of claims 1 to 7, wherein the circuitry (200, 300) comprises multiple receivers (240_1 - 240_N, 244_1 - 244_N), and the multiple receivers (240_1 - 240_N, 244_1 - 244_N) are configured to receive the third signal to generate multiple output signals.

9. The circuitry (200, 300) of claim 8, wherein output terminals of the multiple receivers (240_1 - 240_N, 244_1 - 244_N) are connected together.

10. The circuitry (100, 200, 300) of any one of claims 1 to 9, wherein the first signal, the second signal, the third signal and the output signal are a first clock signal, a second clock signal, a third clock signal and an output clock signal, respectively.
